# EUROPEAN PATENT APPLICATION

(11) **EP 1 583 141 A2**
(43) Date of publication of application: **05.10.2005**
(21) Application number: 05004357.9
(22) Date of filing: 28.02.2005
(51) Int. Cl.: H01L 21/306, H01L 21/3213

(54) **Solvents and methods using same for removing silicon-containing residues from a substrate**

(30) Priority: 02.03.2004 US 549251 P; 18.02.2005 US 60466
(71) Applicant: AIR PRODUCTS AND CHEMICALS, INC., Allentown, PA 18195-1501 (US)
(72) Inventor: Weigel, Scott Jeffrey, Allentown PA 18104 (US); Khot, Shrikant Narendra, Annandale NJ 08801 (US); Morris-Oskanian, Rosaleen Patricia, Collegeville PA 19426 (US); Mayorga, Steven Gerard, Oceanside CA 92056 (US); MacDougall, James Edward, New Tripoli PA 18066 (US); Senecal, Lee, Vista CA 92084 (US)
(74) Representative: Kador & Partner

(57) **Abstract**

A method for the removal of residues comprising silicon from at least a portion of the top and back of a substrate and/or deposition apparatus is disclosed herein. In one aspect, there is provided a method for removing residues comprising: treating the coated substrate and/or deposition apparatus with a removal solvent.

## Description

### CROSS-REFERENCE TO RELATED APPLICATIONS

This application claims the benefit of U.S. Provisional Application No. 60/549,251, filed 2 March 2004.

### BACKGROUND

There is a continuing desire in the microelectronics industry to increase the circuit density in multilevel integrated circuit devices such as memory and logic chips in order to improve the operating speed and reduce power consumption. In order to continue to reduce the size of devices on integrated circuits, it has become necessary to use insulators having a low dielectric constant to reduce the resistance-capacitance ("RC") time delay of the interconnect metallization and to prevent capacitive cross talk between the different levels of metallization. Such low dielectric materials are desirable for premetal dielectric layers and interlevel dielectric layers.

Typical dielectric materials for devices with 180 nm line width are materials with a dielectric constant between about 3.8 and 4.2. As the line width decreases, the dielectric constant should also be decreased. For example, devices with 130 nm line width require materials with a dielectric constant between about 2.5 and 3.0. Extremely low dielectric constant ("ELK") materials generally have a dielectric constant between about 2.0 and 2.5. Devices with 90 nm line width require materials with dielectric constants less than 2.4.

A number of processes have been used for preparing low dielectric constant or low κ films. Chemical vapor deposition (CVD) and spin-on dielectric (SOD) processes are typically used to prepare thin films of insulating layers. A wide variety of low κ materials deposited by these techniques have been generally classified in categories such as purely inorganic materials, ceramic materials, silica-based materials, purely organic materials, or inorganic-organic hybrids. Likewise, a variety of processes have been used for curing these materials to decompose and/or remove volatile components and substantially crosslink the films such as heating, treating the materials with plasmas, electron beams, or UV radiation.

There are typically five steps to the production of spin-on dielectric films. Steps 1 through 3 relate to depositing the film-forming composition onto the substrate; leveling the composition across the substrate; and drying the film. The film-forming composition is typically comprised of a silica source and a solvent. During the depositing step, evaporation of the solvent contained within the film-forming composition occurs to form an uncured film. An edge bead, as used herein, is typically the outermost edge of a film, such as a silica-based, low dielectric constant film, deposited onto a substrate. A solvent is employed to remove the edge bead as well as extraneous material generated during the film-forming process to provide a substantially clean surface on at least a portion of substrate. In step 4, a liquid stream of solvent, which may be also referred to herein as a removal solvent, is deposited onto the edge and spun off to remove the outermost edge of the film. The film is accelerated to remove the solvent and dissolved residues. In step 5, or the bake step, the films are exposed to an energy source (need to define the energy sources), such as thermal, UV, e-beam, infrared, etc to finish the curing process and, in certain embodiments, remove the porogen.

As with photoresists, it may be important to choose the appropriate solvent to remove a portion of the residues such as silicon-containing films on the coated substrates to minimize any defects at the edge, such as loss of planarity of the film (bump at the film edge), improper edge shape (the film that is removed does not result in a sharp step-wise edge transition or the unremoved film has heavily rounded edges), rough edges (poor dissolution of the film or pooling of the edge bead removal solvent at the film edge), film bleed (long thin projections from the edge of the film across the edge bead area), and incomplete removal of the film from the substrate. Since the edge bead removal solvent contacts the substrate, it is preferably that the solvent be free of contaminants such as metals or halides. Common solvents that are used for the removal of positive photoresists include propylene glycol methyl ether acetate (PGMEA), propylene glycol methyl ether, n-butyl acetate, ethyl lactate, diacetone alcohol, ethyl acetyl acetate, acetone, methyl ether ketone, and blends thereof. The aforementioned solvents, however, may be inadequate to remove at least a portion of a silicon-containing film that is deposited onto a substrate and/or the deposition apparatus.

Like the top surface of the substrate, the back side of the substrate and/or the deposition apparatus (e.g., bowl) that is used for depositing the film may also need to be free of particles and contaminants. In this connection, residue present on the back side of the substrate may be detrimental to processing because of contamination to hot plates and/or poor substrate contact with the stepper chucks, i.e., chucks that hold the substrate during lithography, resulting in poor image focus. A solvent may be used to remove these residues on the back surface of the substrate such as, for example, photoresist that curls around the edge of the substrate and/or splashes off the sides or bottom of the deposition apparatus. Moreover, a significant amount of silicon-containing residue may be deposited onto the deposition apparatus itself, such as the interior of the deposition apparatus, during the dispensing, leveling, and/or drying of the film portion of the deposition process. To remedy this, the interior of the deposition apparatus should be cleaned regularly. If the residual material is not removed, particles may form inside the deposition apparatus and get incorporated into or reside on the surface of the as-deposited films. These particles may cause visible defects in the film such as comet trails, holes, and striations. If these particles are incorporated into the as-deposited film, the defects may result in poor imaging during lithography, different etch rates, failure during CMP, barrier defects, shorting between metal lines, and device failure.

### BRIEF SUMMARY

A method for the removal of silicon-containing residues from a substrate and/or deposition apparatus is described herein. In one aspect, there is provided a method for removing residues comprising silicon from at least a portion of coated substrate and/or deposition apparatus comprising: treating the coated substrate and/or deposition apparatus with a removal solvent that boils at a temperature ranging from 120°C to 250°C and has a viscosity of 2.5 centipoise or less.

In another aspect, there is provided a method for removing residues comprising silicon from at least a portion of coated substrate and/or deposition apparatus comprising: treating the coated substrate and/or deposition apparatus with a removal solvent comprising a compound selected from the group consisting of: a compound having the following formula: R¹⁴COR¹⁵CO₂R¹⁶ where R¹⁴ and R¹⁵ are each independently a hydrocarbon group having from 1 to 6 carbon atoms and R¹⁶ is a hydrocarbon group having from 1 to 4 carbon atoms; a compound having the following formula: R¹⁷₃CCO₂-R¹⁸ where R¹⁷ is independently a H atom, an alkoxy group having from 1 to 4 carbon atoms, or a hydrocarbon group having from 1 to 4 carbon atoms and R¹⁸ is a hydrocarbon having from 1 to 8 carbon atoms, an alkyl ether group -(CH₂)ₙ-O-R¹⁹ wherein R¹⁹ is an alkyl group having from 1 to 4 carbon atoms, n is a number ranging from 1 to 4, or an alkylene glycol alkyl ether where the alkylene glycol has from 2 to 4 carbon atoms and the alkyl group has from 1 to 5 carbon atoms; and mixtures thereof.

In a further aspect, there is provided a method for removing residues comprising silicon from at least a portion of a coated substrate comprising: preparing a film-forming composition comprising at least one silica source and at least one solvent; deposited the film-forming composition onto a substrate to provide a coated substrate comprising a silicon-containing film and residues comprising silicon using a deposition apparatus; drying the coated substrate; treating the coated substrate with a removal solvent to remove the residues; removing the removal solvent and residues from the coated substrate to provide a treated substrate; drying the treated substrate; and curing the treated substrate.

These and other aspects will become apparent from the following detailed description.

### BRIEF DESCRIPTION OF THE DRAWINGS

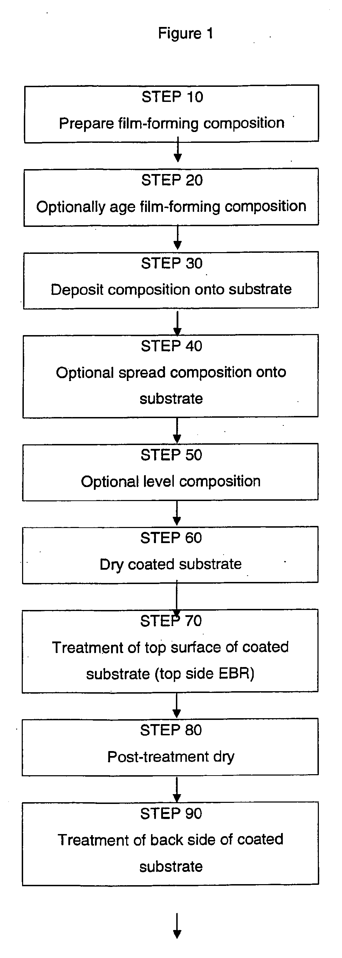

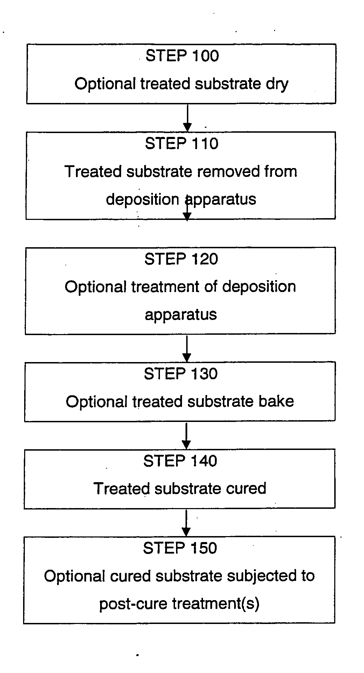

Figure 1 is a flow diagram for one embodiment of the method described herein.

### DETAILED DESCRIPTION

A method for the removal of undesirable residues comprising silicon and/or other elements from at least a portion of a substrate, such as for example, the top surface, back side, and/or deposition apparatus and method comprising same is described herein. Silicon-containing films are desirably deposited onto the top surface of a substrate. However, the edges of the substrate, back side, and/or deposition apparatus may also be deposited with a silicon-containing film or other processing residues. These residues may be liquid, solid, or combinations thereof. Since the chemical make-up and methodology to form polymer photoresists (e.g., organic polymers with minimal hydroxyl content and/or large molecular weight) is significantly different than the film-forming mixture to produce silicon-based films (e.g., contains organic, inorganic components, and/or hydroxyl groups; formed in situ; and/or has small molecular weight polymeric species), solvents used to remove residues comprising photoresist and silicon films are likely to be different. These solvents may not be effective in removing residues derived from film-forming compositions because the solvent may not, for example, provide sufficient solubility to remove these compositions.

Figure 1 provides a flow diagram of one embodiment of the method described herein. As Figure 1 illustrates, step 10 is preparing a film-forming composition. A silicon-containing film is preferably formed from a composition referred to herein as a film-forming composition. The composition may be prepared prior to forming the silicon-containing film or the composition may form during at least a portion of the film-forming process. Depending upon the film formation method, the composition may be deposited onto a substrate as a fluid. The term "fluid", as used herein, denotes a liquid phase, a gas phase, and combinations thereof (e.g., vapor) of the composition.

In step 20, the composition may optionally be aged for a time period ranging from 0.1 hour to 1 week, or from 1 hour to 72 hours, or from 1 hour to 48 hours. Step 20 is typically conducted at ambient temperature, or below.

The film-forming composition generally comprises an at least one silica source and at least one solvent. A "silica source", as used herein, is a compound having silicon (Si) and oxygen (O) and possibly additional substituents such as, but not limited to, other elements such as H, B, C, P, or halide atoms and organic groups such as alkyl groups; or aryl groups. The composition may further include other constituents such as, but not limited to, water, one or more porogen, catalyst, and/or ionic additives. In embodiments where the composition includes a porogen, the weight ratio of porogen to the combined weight of porogen and SiO₂, i.e. void fraction, ranges from 0.9 to 0.1. This range may vary depending upon the desired dielectric constant of the material produced from the composition since the dielectric constant of the material is inversely proportional to the weight ratio of the porogen or directly proportional to the void fraction of the composition/film. In the foregoing ratio, the weight of SiO₂ is calculated from the total number of moles of silicon introduced by the silica sources within the composition. This, however, does not necessarily imply that the silica sources are completely converted to SiO₂. In embodiments where the composition contains an ionic additive, the weight ratio of ionic additive to weight of porogen ranges from 0.5 to 0. In another embodiment, the molar ratio of R, or organic constituents, to Si ranges from 0.2 to 3, or from 0.2 to 2, or from 0.2 to 1. In a further embodiment, the molar ratio of water to OR group(s), wherein OR is an organic group bonded to silicon through an oxygen atom may range from 40 to 0.5. In yet another embodiment, the material may further comprise silicon-carbon bonds having a total number of Si-C bonds to the total number of Si atoms ranging from between about 20 to about 80 mole percent or from between about 40 to about 60 mole percent.

The film-forming composition and/or process for preparing the film uses chemicals within the composition and/or during processing that meet the requirements of the electronics industry because it contains little to no contaminants, such as, for example, metals, halides, and/or other compounds that may adversely affect the electrical properties of the film. Constituents like halogen-containing mineral acids, cationic surfactants with halide counter ions, and anionic surfactants with alkali metal counter ions are preferably avoided in the composition because they may contribute undesirable ions to the materials of the invention. The solvents used herein may contain contaminating metals in amounts less than 1 parts per million ("ppm"), or less than 200 parts per billion ("ppb"), or less than 50 ppb. Consequently, materials of the invention may contain contaminating metals in amounts less than 1 parts per million ("ppm"), or less than 200 parts per billion ("ppb"), or less than 50 ppb. Materials of the invention preferably contain contaminating halides in amounts less than 1 ppm, or less than 750 ppb, or less than 500 ppb. In addition, in certain embodiments, the chemical reagents within the film-forming composition contain contaminating metals in amounts less than 1 parts per million ("ppm"), or less than 200 parts per billion ("ppb"), or less than 50 ppb. In certain embodiments, if the chemical reagent contains 1 ppm or greater of contaminating metals, the chemical reagent may be purified prior to addition to the composition. Pending U.S. Published Application 2004-0048960, which is incorporated herein by reference and assigned to the assignee of the present application, provides examples of suitable chemicals and methods for purifying same that can be used in the film-forming composition.

The following are non-limiting examples of silica sources suitable for use in the composition and method of the present invention. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula RₐSi(OR¹)₄₋ₐSi, when "a" is 2, the two R groups need not be identical to each other or to R¹.

The term "monovalent organic group" as used herein relates to an organic group bonded to an element of interest, such as Si or O, through a single C bond, i.e., Si-C or O-C. Examples of monovalent organic groups include an alkyl group, an aryl group, an unsaturated alkyl group, and/or an unsaturated alkyl group substituted with alkoxy, ester, acid, carbonyl, or alkyl carbonyl functionality. The alkyl group may be a linear, branched, or cyclic alkyl group having from 1 to 5 carbon atoms such as, for example, a methyl, ethyl, propyl, butyl, or pentyl group. Examples of aryl groups suitable as the monovalent organic group include phenyl, methylphenyl, ethylphenyl and fluorophenyl. In certain embodiments, one or more hydrogen atoms within the alkyl group may be substituted with an additional atom such as a halide atom (i.e., fluorine), or an oxygen atom to give a carbonyl or ether functionality.

In certain embodiments, the silica source may be represented by the following formula: RₐSi(OR¹)₄₋ₐ, wherein R independently represents a hydrogen atom, a fluorine atom, or a monovalent organic group; R¹ independently represents a monovalent organic group; and a is an integer ranging from 1 to 2. Specific examples of the compounds represented by RₐSi(OR¹)₄₋ₐ include: methyltrimethoxysilane, methyltriethoxysilane, methyltri-n-propoxysilane, methyltri-iso- propoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriphenoxysilane, n-propyltrimethoxysilane, n-propyltriethoxysilane, n-propyltri-n-propoxysilane, n-propyltri-iso-propoxysilane, n-propyltin-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n- butyltriisopropoxysilane, n-butyltri-n-butoxysilane, n-butyltri-sec-butoxysilane, n-butyltri-tert-butoxysilane, n-butyltriphenoxysilane; sec-butyltrimethoxysilane, sec-butyltriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, isobutyltrimethoxysilane, isobutyltriethoxysilane, isobutyltri-n-propoxysilane, isobutyltriisopropoxysilane, isobutyltri-n-butoxysilane, isobutyltri-sec-butoxysilane, isobutyltri-tert-butoxysilane, isobutyltriphenoxysilane, n-pentyltrimethoxysilane, n-pentyltriethoxysilane, n-pentyltri-n-propoxysilane, n-pentyltriisopropoxysilane, n-pentyltri-n-butoxysilane, n-pentyltri-sec-butoxysilane, n-pentyltri-tert-butoxysilane, n-pentyltriphenoxysilane; sec-pentyltrimethoxysilane, sec-pentyltriethoxysilane, sec-pentyltri-n-propoxysilane, sec-pentyltriisopropoxysilane, sec-pentyltri-n-butoxysilane, sec-pentyltri-sec-butoxysilane, sec-pentyltri-tert-butoxysilane, sec-pentyltriphenoxysilane, tert-pentyltrimethoxysilane, tert-pentyltriethoxysilane, tert-pentyltri-n-propoxysilane, tert-pentyltriisopropoxysilane, tert-pentyltri-n-butoxysilane, tert-pentyltri-sec-butoxysilane, tert-pentyltri-tert-butoxysilane, tert-pentyltriphenoxysilane, isopentyltrimethoxysilane, isopentyltriethoxysilane, isopentyltri-n-propoxysilane, isopentyltriisopropoxysilane, isopentyltri-n-butoxysilane, isopentyltri-sec-butoxysilane, isopentyltri-tert-butoxysilane, isopentyltriphenoxysilane, neo-pentyltrimethoxysilane, neo-pentyltriethoxysilane, neo-pentyltri-n-propoxysilane, neo-pentyltriisopropoxysilane, neo-pentyltri-n-butoxysilane, neo-pentyltri-sec-butoxysilane, neo-pentyltri-neo-butoxysilane, neo-pentyltriphenoxysilane phenyltrimethoxysilane, phenyltriethoxysilane, phenyltri-n-propoxysilane, phenyltriisopropoxysilane, phenyltri-n-butoxysilane, phenyltri-sec-butoxysilane, phenyltri-tert-butoxysilane, phenyltriphenoxysilane, δ-trifluoropropyltrimethoxysilane, δ-trifluoropropyltriethoxysilane, dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldimethoxysilane, di-n-propyldi-n-propoxysilane, di-n-propyldiisopropoxysilane, di-n-propyldi-n-butoxysilane, di-n-propyldi-sec-butoxysilane, din-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n- butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, methylneopentyldimethoxysilane, methylneopentyldiethoxysilane, methyldimethoxysilane, ethyldimethoxysilane, n-propyldimethoxysilane, isopropyldimethoxysilane, n-butyldimethoxysilane, sec-butyldimethoxysilane, tert-butyldimethoxysilane, isobutyldimethoxysilane, n-pentyldimethoxysilane, sec-pentyldimethoxysilane, tert-pentyldimethoxysilane, isopentyldimethoxysilane, neopentyldimethoxysilane, neohexyldimethoxysilane, cyclohexyldimethoxysilane, phenyldimethoxysilane, methyldiethoxysilane, ethyldiethoxysilane, n-propyldiethoxysilane, isopropyldiethoxysilane, n-butyldiethoxysilane, sec-butyldiethoxysilane, tert-butyldiethoxysilane, isobutyldiethoxysilane, n-pentyldiethoxysilane, sec-pentyldiethoxysilane, tert-pentyldiethoxysilane, isopentyldiethoxysilane, neopentyldiethoxysilane, neohexyldiethoxysilane, cyclohexyldiethoxysilane, phenyldiethoxysilane, trimethoxysilane, triethoxysilane, tri-n-propoxysilane, triisopropoxysilane, tri-n-butoxysilane, tri-sec-butoxysilane, tri-tert-butoxysilane, triphenoxysilane, allyltrimethoxysilane, allyltriethoxysilane, vinyltrimethoxsilane, vinyltriethoxysilane, (3-acryloxypropyl)trimethoxysilane, allyltrimethoxysilane, allyltriethoxysilane, vinyltrimethoxsilane, vinyltriethoxysilane, and (3-acryloxypropyl)trimethoxysilane. Of the above compounds, the preferred compounds are methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, and diethyldiethoxysilane.

The silica source may be a compound having the formula Si(OR²)₄ wherein R² independently represents a monovalent organic group. Specific examples of the compounds represented by Si(OR²)₄ include tetramethoxysilane, tetraethoxysilane, tetra-n-propoxysilane, tetraisopropoxysilane, tetra-n-butoxysilane, tetra-sec-butoxysilane, tetra- tert-butoxysilane, tetraacetoxysilane, and tetraphenoxysilane. Of the above, certain preferred compounds may include tetramethoxysilane, tetraethoxysilane, tetra-n-propoxysilane, tetraisopropoxysilane, or tetraphenoxysilane.

The silica source may be a compound having the formula R³_{b}(R⁴O)_{3-b}Si-(R⁷)-Si(OR⁵)_{3-c}R⁶_{c}, wherein R³ and R⁶ are independently a hydrogen atom, a fluorine atom, or a monovalent organic group; R⁴ and R⁵ are independently a monovalent organic group; b and c may be the same or different and each is a number ranging from 0 to 2; R⁷ is an oxygen atom, a phenylene group, a biphenyl, a naphthalene group, or a group represented by -(CH₂)ₙ-, wherein n is an integer ranging from 1 to 6; or combinations thereof. Specific examples of these compounds wherein R⁷ is an oxygen atom include: hexamethoxydisiloxane, hexaethoxydisiloxane, hexaphenoxydisiloxane, 1,1,1,3,3-pentamethoxy-3- methyldisiloxane, 1,1,1,3,3-pentaethoxy-3-methyldisiloxane, 1,1,1,3,3-pentamethoxy-3-phenyldisiloxane, 1,1,1,3,3-pentaethoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,1,3,3-tetraethoxy-1,3-diphenyldisiloxane, 1,1,3-trimethoxy-1,3,3-trimethyldisiloxane, 1,1,3-triethoxy-1,3,3-trimethyldisiloxane, 1,1,3-trimethoxy-1,3,3-triphenyldisiloxane, 1,1,3-triethoxy-1,3,3-triphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane and 1,3-diethoxy-1,1,3,3-tetraphenyldisiloxane.
Of those, preferred compounds are hexamethoxydisiloxane, hexaethoxydisiloxane, hexaphenoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane;1,3-diethoxy-1,1,3,3-tetraphenyldisiloxane. Specific examples of these compounds wherein R⁷ is a group represented by -(CH₂)ₙ- include: bis(trimethoxysilyl)methane, bis(triethoxysilyl)methane, bis(triphenoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane, bis(ethoxydiphenylsilyl)methane, 1,2-bis(trimethoxysilyl)ethane, 1,2-bis(triethoxysilyl)ethane, 1,2-bis(triphenoxysilyl)ethane, 1,2-bis(dimethoxymethylsilyl)ethane, 1,2-bis(diethoxymethylsilyl)ethane, 1,2-bis(dimethoxyphenylsilyl)ethane, 1,2-bis(diethoxyphenylsilyl)ethane, 1,2-bis(methoxydimethylsilyl)ethane, 1,2-bis(ethoxydimethylsilyl)ethane, 1,2-bis(methoxydiphenylsilyl)ethane, 1,2-bis(ethoxydiphenylsilyl)ethane, 1,3-bis(trimethoxysilyl)propane, 1,3-bis(triethoxysilyl)propane, 1,3-bis(triphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimethylsilyl)propane, 1,3-bis(ethoxydimethylsilyl)propane, 1,3-bis(methoxydiphenylsilyl)propane, and 1,3-bis(ethoxydiphenylsilyl) propane. Of those, preferred compounds are bis(trimethoxysilyl)methane, bis(triethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane and bis(ethoxydiphenylsilyl)methane.

In certain embodiments of the present invention, R¹ of the formula RₐSi(OR¹)₄₋ₐ; R² of the formula Si(OR²)₄; and R⁴ and/or R⁵ of the formula R³_{b}(R⁴O)_{3-b}Si-(R⁷)-Si(OR⁵)_{3-c}R⁶_{c} can each independently be a monovalent organic group of the formula: 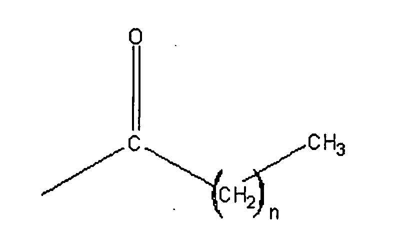 wherein n is an integer ranging from 0 to 4. Specific examples of these compounds include: tetraacetoxysilane, methyltriacetoxysilane, ethyltriacetoxysilane, n-propyltriacetoxysilane, isopropyltriacetoxysilane, n-butyltriacetoxysilane, sec-butyltriacetoxysilane, tert-butyltriacetoxysilane, isobutyltriacetoxysilane, n-pentyltriacetoxysilane, sec-pentyltriacetoxysilane, tert-pentyltriacetoxysilane, isopentyltriacetoxysilane, neopentyltriacetoxysilane, phenyltriacetoxysilane, dimethyldiacetoxysilane, diethyldiacetoxysilane, di-n-propyldiacetoxysilane, diisopropyldiacetoxysilane, di-n-butyldiacetoxysilane, di-sec-butyldiacetoxysilane, di-tert-butyldiacetoxysilane, diphenyldiacetoxysilane, triacetoxysilane. Of these compounds, tetraacetoxysilane and methyltriacetoxysilane are preferred.

Other examples of the at least one silica source may include a fluorinated silane or fluorinated siloxane such as those provided in U. S. Pat. No. 6,258,407.

Another example of at least one silica source may include compounds that produce a Si-H bond upon elimination.

Still further examples of the at least one silica source are found in the non-hydrolytic chemistry methods described, for example, in the references Hay et al., "Synthesis of Organic-Inorganic Hybrids via the Non-hydrolytic Sol-Gel Process", Chem. Mater., 13, 3396-3403 (2001) or Hay, et al., "A Versatile Route to Organically-Modified Silicas and Porous Silicas via the Non-Hydrolytic Sol-Gel Process", J. Mater. Chem., 10, 1811-1818 (2000).

Still other examples of silica sources include silsesquioxanes such as hydrogen silsesquioxanes (HSQ, HSiO_{1.5}) and methyl silsesquioxanes (MSQ, RSiO_{1.5} where R is a methyl group).

In certain embodiments, the at least one silica source may preferably have an at least one carboxylic acid ester bonded to the Si atom. Examples of these silica sources include tetraacetoxysilane, methyltriacetoxysilane, ethyltriacetoxysilane, and phenyltriacetoxysilane. In addition to the at least one silica source wherein the silica source has at least one Si atom having an carboxylate group attached thereto, the composition may further comprise additional silica sources that may not necessarily have the carboxylate attached to the Si atom.

In some embodiments, a combination of hydrophilic and hydrophobic silica sources is used in the composition. The term "hydrophilic", as used herein, refers to compounds wherein the silicon atom can crosslink through at least four bonds. In these embodiments, the ratio of hydrophobic silica source to the total amount of silica source is greater than about 0.2 molar ratio or from 0.2 to 0.8 molar ratio. Some examples of hydrophilic sources include alkoxysilanes having an alkoxy functionality and can at least partially crosslink, i.e., a Si atom with four methoxy, ethoxy, propoxy, acetoxy, etc. groups, or materials with carbon or oxygen bonds between Si atoms and all other functionality on the Si atoms being an alkoxide. If the Si atoms do not fully crosslink, residual Si-OH groups may be present as terminal groups that can adsorb water. The term "hydrophobic" refers to compounds where at least one of the alkoxy functionalities has been replaced with a terminal Si-C or Si-F bond, i.e. Si-methyl, Si-ethyl, Si-phenyl, Si-cyclohexyl, etc., that would not generate a hydroxyl after hydrolysis. In these sources, the silicon would crosslink with less than four bridges even when fully crosslinked as a result of hydrolysis and condensation of Si-OH groups if the terminal group remains intact. In certain embodiments, the hydrophobic silica source contains a methyl group attached to the silicon atom.

The film-forming composition disclosed herein includes at least one solvent. Exemplary at least one solvents useful for the film-forming composition can be alcohol solvents, ketone solvents, amide solvents, or ester solvents. The solvents could also have hydroxyl, carbonyl, or ester functionality. In certain embodiments, the solvent has one or more hydroxyl or ester functionalities such as those solvents having the following formulas: HO-CHR⁸-CHR⁹-CH₂-CHR¹⁰R¹¹ where R⁸, R⁹, R¹⁰, and R¹¹ can independently be an alkyl group ranging from 1 to 4 carbon atoms or a hydrogen atom; and R¹²-CO-R¹³ where R¹² is a hydrocarbon group having from 3 to 6 carbon atoms; R¹³ is a hydrocarbon group having from 1 to 3 carbon atoms; and mixtures thereof. Additional exemplary solvents include alcohol isomers having from 4 to 6 carbon atoms, ketone isomers having from 4 to 8 carbon atoms, linear or branched hydrocarbon acetates where the hydrocarbon has from 4 to 6 carbon atoms, ethylene or propylene glycol ethers, ethylene or propylene glycol ether acetates. Other solvents that can be used include 1-pentanol, 2-pentanol, 2-methyl-1-butanol, 2-methyl-1-pentanol, 2-ethoxyethanol, 2-propoxyethanol, 1-propoxy-2-propanol, 2-heptanone, 4-heptanone, 1-tert-butoxy-2-ethoxyethane, 2-methoxyethylacetate, propylene glycol methyl ether acetate, pentyl acetate, 1-tert-butoxy-2-propanol, 2,3-dimethyl-3-pentanol, 1-methoxy-2-butanol, 4-methyl-2-pentanol, 1-tert-butoxy-2-methoxyethane, 3-methyl-1-butanol, 2-methyl-1-butanol, 2-methoxyethanol, 3-methyl-2-pentanol, 1,2-diethoxyethane, 1-methoxy-2 propanol, 1-butanol, 3-methyl-2-butanol, 5-methyl-2-hexanol. Still further exemplary solvents include lactates, pyruvates, and diols. The solvents enumerated above may be used alone or in combination of two or more solvents.

In certain embodiments, the film-forming composition comprises a porogen. A "porogen", as used herein, is a reagent that is used to generate void volume within the resultant film. Suitable porogens for use in the dielectric materials of the present invention include labile organic groups, solvents, decomposable polymers, surfactants, dendrimers, hyper-branched polymers, polyoxyalkylene compounds, organic macromolecules, or combinations thereof. Still further examples of suitable porogens include those porogens described in pending patent application, Attorney Docket 06274P2, which is assigned to the assignee of the present invention.

In certain embodiments of the present invention, the porogen may include labile organic groups. When some labile organic groups are present in the composition, the labile organic groups may contain sufficient oxygen to convert to gaseous products during the cure step. Some examples of compounds containing labile organic groups include the compounds disclosed in U. S. Pat. No. 6,171,945, which is incorporated herein by reference in its entirety.

In some embodiments of the present invention, the porogen may be a high boiling point solvent. In this connection, the solvent is generally present during at least a portion of the cross-linking of the matrix material. Solvents typically used to aid in pore formation have relatively higher boiling points, i.e., greater than 170°C or greater than 200°C. Solvents suitable for use as a porogen within the composition of the present invention include those solvents provided, for example, in U. S. Pat. No. 6,231,989.

In certain embodiments, the porogen may be a small molecule such as those described in the reference Zheng, et al., "Synthesis of Mesoporous Silica Materials with Hydroxyacetic Acid Derivatives as Templates via a Sol-Gel Process", J. Inorg. Organomet. Polymers, 10, 103-113 (2000) or quartemary ammonium salts such as tetrabutylammonium nitrate.

The porogen could also be a decomposable polymer. The decomposable polymer may be radiation decomposable, or more preferably, thermally decomposable. The term "polymer", as used herein, also encompasses the terms oligomers and/or copolymers unless expressly stated to the contrary. Radiation decomposable polymers are polymers that decompose upon exposure to radiation, e.g., ultraviolet, X-ray, electron beam, or the like. Thermally decomposable polymers undergo thermal decomposition at temperatures that approach the condensation temperature of the silica source materials and are present during at least a portion of the cross-linking. Such polymers are those that may foster templating of the vitrification reaction, may control and define pore size, and/or may decompose and diffuse out of the matrix at the appropriate time in processing. Examples of these polymers include polymers that have an architecture that provides a three-dimensional structure such as, but not limited to, block copolymers, i.e., diblock, triblock, and multiblock copolymers; star block copolymers; radial diblock copolymers; graft diblock copolymers; cografted copolymers; dendrigraft copolymers; tapered block copolymers; and combinations of these architectures. Further examples of degradable polymers are found in U. S. Pat. No. 6,204,202, which is incorporated herein by reference in its entirety.

The porogen may be a hyper branched or dendrimeric polymer. Hyper branched and dendrimeric polymers generally have low solution and melt viscosities, high chemical reactivity due to surface functionality, and enhanced solubility even at higher molecular weights. Some non-limiting examples of suitable decomposable hyper-branched polymers and dendrimers are provided in "Comprehensive Polymer Science", 2^{nd} Supplement, Aggarwal, pp. 71-132 (1996) that is incorporated herein by reference in its entirety.

The porogen within the film-forming composition may also be a polyoxyalkylene compound such as polyoxyalkylene non-ionic surfactants, polyoxyalkylene polymers, polyoxyalkylene copolymers, polyoxyalkylene oligomers, or combinations thereof. An example of such is a polyalkylene oxide that includes an alkyl moiety ranging from C₂ to C₆ such as polyethylene oxide, polypropylene oxide, and copolymers thereof.

The porogen could also comprise a surfactant. For silica sol-gel based films in which the porosity is introduced by the addition of surfactant that is subsequently removed, varying the amount of surfactant can vary porosity. Typical surfactants exhibit an amphiphilic nature, meaning that they can be both hydrophilic and hydrophobic at the same time. Amphiphilic surfactants possess a hydrophilic head group or groups, which have a strong affinity for water and a long hydrophobic tail that is organophilic and repels water. The surfactants can be anionic, cationic, nonionic, or amphoteric. Further classifications of surfactants include silicone surfactants, poly(alkylene oxide) surfactants, and fluorochemical surfactants. However, for the formation of dielectric layers for IC applications, non-ionic surfactants are generally preferred. Suitable surfactants for use in the composition include, but are not limited to, octyl and nonyl phenol ethoxylates such as TRITON® X-114, X-102, X-45, X-15; alcohol ethoxylates such as BRIJ® 56 (C₁₆H₃₃(OCH₂CH₂)₁₀OH) (ICI), BRIJ® 58 (C₁₆H₃₃(OCH₂CH₂)₂₀OH) (ICI), and acetylenics diols such as SURFYNOLS® 465 and 485 (Air Products and Chemicals, Inc.). Further surfactants include polymeric compounds such as the tri-block EO-PO-EO co-polymers PLURONIC® L121, L123, L31, L81, L101 and P123 (BASF, Inc.). Still further exemplary surfactants include alcohol (primary and secondary) ethoxylates, amine ethoxylates, glucosides, glucamides, polyethylene glycols, poly(ethylene glycol-co-propylene glycol), or other surfactants provided in the reference *McCutcheon's Emulsifiers and Detergents*, North American Edition for the Year 2000 published by Manufacturers Confectioners Publishing Co. of Glen Rock, N.J.

Referring again to Figure 1 in step 30, the film-forming composition is deposited onto a substrate to provide a coated substrate. The term substrate, as used herein, is any suitable composition that is formed before the dielectric film of the present invention is applied to and/or formed on that composition. Suitable substrates that may be used in conjunction with the present invention include, but are not limited to, semiconductor materials such as gallium arsenide ("GaAs"), silicon, and compositions containing silicon such as crystalline silicon, polysilicon, amorphous silicon, epitaxial silicon, silicon dioxide ("SiO₂"), and mixtures thereof. Other suitable substrates include chromium, molybdenum, and other metals commonly employed in semiconductor, integrated circuit, flat panel display, and flexible display applications. The composition may be deposited onto the substrate via a variety of methods including, but not limited to, dipping, rolling, brushing, spraying, extrusion, spin-on deposition, printing, and combinations thereof. Further exemplary deposition methods for step 30 include oscillating non-contact induced spreading forces, gravity-induced spreading forces, wetting-induced spreading forces, slot extrusion, and combinations thereof.

In one particular embodiment, step 30 is conducted using a spin-on deposition method. In brief, the film-forming composition is dispensed onto a substrate and the solvent contained therein is evaporated to form the coated substrate. Further, centrifugal force is used to ensure that the composition is uniformly deposited onto the substrate. In these embodiments, the spin-on deposition apparatus, or deposition apparatus configuration, may be a closed, a semi-closed, or an open spinning bowl configuration.
In a closed spinning bowl configuration, there is a lid present on the spinning chamber that remains closed during the spreading, thinning, and drying of the film. Like the closed spinning bowl configuration, a semi-closed bowl has a lid or platen present that can be adjusted throughout the film formation process but does allow for the film to be exposed to environmental conditions during dispense and film formation. Adjustment of the lid or platen controls the turbulence and evaporation process of the solvent as it leaves the film allowing for excellent control of the film-forming process. In an open spinning bowl configuration, there is no lid present on the process tool.

In certain embodiments of the method described herein, where steps 40 and 50, or.the spreading and leveling steps are conducted, the composition is spread onto the substrate and then leveled to provide a substantially uniform coating. After the coated substrate is formed, in step 60, the coated substrate may be dried to, for example, substantially complete the hydrolysis of the silica source, continue the crosslinking process, and/or drive off remaining solvent, if present, from the film.

Referring to Figure 1, treatment step 70 is performed to remove residues from the top side edge of the substrate. Examples of suitable removal solvents include compounds having the following formulas: R¹⁴COR¹⁵CO₂R¹⁶ where R¹⁴ and R¹⁵ are independently a hydrocarbon group having from 1 to 6 carbon atoms and R¹⁶ is a hydrocarbon group having from 1 to 4 carbon atoms; and R¹⁷₃CCO₂-R¹⁸ where R¹⁷ is independently a H atom, an alkoxy group having from 1 to 4 carbon atoms, or a hydrocarbon group having from 1 to 4 carbon atoms and R¹⁸ is a hydrocarbon having from 1 to 8 carbon atoms, an alkyl ether group -(CH₂)ₙ-O-R¹⁹ wherein R¹⁹ is an alkyl group having from 1 to 4 carbon atoms, n is a number ranging from 1 to 4, or an alkylene glycol alkyl ether where the alkylene glycol has from 2 to 4 carbon atoms and the alkyl group has from 1 to 5 carbon atoms. In the foregoing formulas, the term "hydrocarbon group" refers to a group that contains only carbon and hydrogen atoms; may be linear, branched or cyclic; and may be saturated or unsaturated. Specific examples of removal solvents include ethylacetoacetate, methyl acetoacetate, allyl acetoacetate, t-butyl acetoacetate, methyl benzoate, propionic anhydride, ethyl-3-ethoxypropionate, 2-butoxyethyl acetate, hexyl acetate, di-n-propyl carbonate, and mixtures thereof. Further examples of suitable removal solvents include acetophenone, benzylamine, furfural, diglyme, and tetramethyl urea.

In certain embodiments, the removal solvent is different from the at least one solvent in the film-forming composition. However, in alternative embodiments, the removal solvent may be the same as the solvent employed in the film-forming composition such as any of the solvents disclosed herein.

Like the at least one solvent within the film-forming composition, the boiling point, surface tension, solubility parameter, and viscosity may effect the performance of the removal solvent. Table I illustrates that the certain removal solvents may be effective for removing silicon-containing residues. It is preferable that the removal solvent exhibits one or more of the following characteristics: has a boiling point that is high enough to maximize the time of the interaction of the solvent with the film yet low enough to evaporate at the end of the process; has a sufficient surface tension and viscosity to stay on the edge of the substrate and not diffuse into the film causing a bump; should solubilize the silicon-containing residues effectively; remove the material from the edge of the coated substrate without leaving residue (substrate edge cleanliness); remove the entire thickness of the film (solubility of the silicate polymers); produce a sharp, properly shaped film edge; and/or not cause swelling of the film remaining on the substrate. If the surface planarity of the film has changed or the edge shape is not sharp as a result of treatment step 70, it is likely that subsequent processing steps such as chemical mechanical planarization (CMP) may delaminate or dish the dielectric layers. In certain embodiments, the removal solvent does not have hydroxyl functionality. In other embodiments, the removal solvent boils at a temperature ranging from 120°C to 250°C or from 150°C to 250°C. In still other embodiments, the viscosity of the removal solvent may be 2.5 centipoise or less (cP). In yet another embodiment, the surface tension of the removal solvent is 22 dyne/cm or greater. In still a further embodiment, the solubility parameter of the removal solvent is 17 (J/m³)^{1/2} or greater.

**Table I:**

| Exemplary Removal solvents and Characteristics thereof | | | | | |
|---|---|---|---|---|---|
| Solvent | δ (J/cm³)^{1/2} | γ (dyne/cm) | BP (°C) | P_{VAP} (psia) | η (cP) |
| Methyl Acetoacetate | 21.68 | 37.12 | 171.7 | 0.017 | 1.61 |
| Allyl acetoacetate | 20.4 | n/a | 194 | n/a | 1.62 |
| t-Butyl Acetoacetate | 18.01 | 22.4 | 190 | 0.008 | n/a |
| Methyl Benzoate | 20.46 | 37.2 | 198 | 0.007 | 1.9 |
| Acetophenone | 20.93 | 39 | 202 | 0.007 | 1.7 |
| Benzylamine | 21.76 | 39.3 | 184 | 0.013 | 1.6 |
| Furfural | 23.61 | 43.1 | 162 | 0.044 | 1.6 |
| Propionic Anhydride | 19.55 | 29.9 | 167 | 0.026 | 1.04 |
| Ethyl-3-ethoxypropionate (EEP) | 18.23 | 27.5 | 165 | 0.051 | 1.19 |
| Diglyme ⁽¹⁾ | 18.67 | 29.2 | 162 | 0.068 | 1 |
| Tetramethyl Urea | n/a | 32.9 | 177 | 0.035 | 1.41 |
| Di-n-propyl Carbonate | n/a | 26.2 | 165 | 0.057 | 1.25 |
| 2-Butoxyethyl Acetate ⁽²⁾ | 18.22 | 27.4 | 192 | 0.017 | 1.7 |
| Hexyl Acetate | n/a | 27 | 172 | 0.027 | 1.08 |

| | | | | | |
|---|---|---|---|---|---|
| (1) Diethylene Glycol Dimethyl Ether | | | | | |
| (2) Glycol Ether EB Acetate, Eastman EB acetate. n/a = property could not be found | | | | | |

In one particular embodiment, treatment step 70 is performed immediately after dry step 60 if dry step 60 is conducted using centrifugal forces. In this embodiment, the coated substrate may decelerated from its initial drying cycle so that the coated substrate is rotating at a speed ranging from 500 to 3000 rpm during at least a portion of treatment step 70. The removal solvent may be dispensed onto the coated substrate through, for example, a pressure-driven nozzle. The nozzle can be, for example, a tube, pipe, or an orifice. In embodiments wherein a nozzle is used for dispensing, the inner diameter of the nozzle, which could have a cross-section of a variety of different geometries (i.e., circular, square, ovular, etc.), is 0.7 mm or less. The angle at which the nozzle is oriented to the top surface of the coated substrate 70° or less to the substrate surface. The angle at which the nozzle is oriented to the substrate edge is 120° or less. The removal solvent may be applied to the substrate edge for a time ranging from, for example, 1 to 180 seconds, to create the film edge and clean the outer portion of the substrate

At the completion of treatment step 70, in step 80 the substrate is dried to remove the removal solvent from the treated substrate. In certain embodiments, the drying step 80 is conducting using centrifugal forces. In these embodiments, the substrate may be accelerated to remove the removal solvent and finish drying the film.

In certain embodiments, the back side of the substrate may also be treated with a removal solvent. In optional step 90 and optional step 100, the back surface of the substrate may be treated with a removal solvent and dried, respectively, to remove any residues from the back surface or underside of the treated substrate. Step 90 can be performed during at least a portion of the top side edge bead removal (i.e., step 70) or after top side edge bead removal is completed. The residues on the back surface may contain silicon, photoresist, or other materials. In certain preferred embodiments, steps 90 and 100 are conducted in the same manner as steps 70 and 80. This solvent used in step 90 can be the removal solvent, the solvent from the film-forming composition, or any solvent that is capable of removing residues from the back side of the substrate. The choice of solvent will vary depending upon the residues to be removed. In certain embodiments, the removal solvent used for the back side rinse should have an adequate solubility parameter for the film, preferably 25 (J/cm³)^{1/2} or less, and a boiling point of 250°C or less.

As described earlier, in removal step 70 it is necessary to remove the residue such as the outer edge of the top surface of the coated substrate, so that additional handling of the substrate does not cause any damage to the film or generate any additional particulates. When the removal solvent is sprayed as a liquid stream onto the edge, preferably pressure or mechanically driven, a balance should be established between the chemical and mechanical removal of the film from the substrate surface to produce acceptable film edge shapes. For example, if the mechanical removal of the film occurs quickly and there is not enough film solubility in the removal solvent the edges of the film are rough or the materials dissolved in the solvent can be re-deposited onto the film edge leaving residues and rough surfaces. Any residues or edge defects can lead to defects in the film stack and device failure. In contrast to step 70, in certain embodiments, step 90 or the residue removal on the back surface is more important rather than the edge shape. In this step, the solubility of the residue in the solvent is imperative to provide clean back surfaces.

In step 120, the deposition apparatus used during processing is also treated with a removal solvent to remove any residues from the bottom and sides of the apparatus resulting from processing. Treatment of the deposition apparatus may reduce the accumulation of silicon-containing and other processing residues on the interior surfaces of the apparatus thereby reducing the potential for particulate generation during processing of subsequent substrates. Depending upon assembly line requirements, step 120 can be conducted after the processing of each individual substrate or conducted after the processing of a number of substrates. The solvent used for treating the deposition apparatus should exhibit one of more of the following characteristics: be able to adequately remove the residues deposited thereupon such as film-forming composition; have a total solubility parameter of 25 (J/cm³)^{1/2} or less; and/or evaporate quickly by having a boiling point of 250°C or less so that solvent vapors in the deposition apparatus are minimized. If a significant vapor pressure of solvent remains in the deposition apparatus, films that are deposited onto substrates in the deposition apparatus may be affected by the solvent in the atmosphere thereby changing the evaporation behavior of the film-forming composition. It is believed that these changes may cause inconsistent film thickness, uniformities, dielectric constants, and moduli within the substrate and unacceptable film to film variations between subsequent substrates.

In step 130, the treated substrate is then baked at one or more temperatures less than 300°C. Specific temperature and time durations will vary depending upon the ingredients within the composition, the substrate, and the desired pore volume. In certain embodiments, the cure step is conducted at two or more temperatures rather than a controlled ramp or soaks. The first temperature, typically below 300°C, may be to remove the water and/or solvent from the material or film and to further cross-linking reactions. The second temperature may be to remove the porogen and to substantially, but not necessarily completely, cross-link the material. Bake step 130 is preferably conducted via thermal methods such as a hot plate, oven, furnace or the like. For thermal methods, bake step 130 may be conducted under controlled conditions such as atmospheric pressure using nitrogen, inert gas, air, or other N₂/O₂ mixtures (0-21 % O₂), vacuum, or under reduced pressure having controlled oxygen concentration.

After bake step 130 is completed, the treated substrate is cured in step 140. In certain embodiments, cure step 140 is conducted by heating the treated substrate heated to one or more temperatures ranging from about 250 to about 450°C, or more preferably about 400°C or below. The cure step 140 can be conducted for a time of about 30 minutes or less, or about 15 minutes or less, or about 6 minutes or less. Alternatively, cure step 140 may be conducted by electron-beam, ozone, plasma, X-ray, ultraviolet radiation or other means. Curing conditions such as time, temperature, and atmosphere may vary depending upon the method selected. In certain embodiments, curing step 140 is conducted via a thermal method in an air, nitrogen, or inert gas atmosphere, under vacuum, or under reduced pressure having an oxygen concentration of 10% or lower.

In optional step 150, the substrate may be further subjected to post cure steps such as a post-cure e-beam, UV, X-ray or other treatments. Unlike chemical post treatments such as those described in U.S. Pat. No. 6,329,017, these treatments may, for example, increase the mechanical integrity of the material or decrease the dielectric constant by reducing hydroxyl groups that in turn reduce sites likely to adsorb water.

### EXAMPLES

In the following examples, unless stated otherwise, properties were obtained from sample films that were spun onto a low resistance (0.01 Ωcm) single crystal silicon substrate and heated to 400°C. For the thickness values, the error between the simulated thickness and actual film thickness values measured by profilometry was generally less than 2%. Uniformity across 200 and 300 mm substrates was performed on a Rudolph Model # Focus Fe IV-D spectroscopic ellipsometer tool using a standard 49 point substrate map.

Surface tension is measured using the Wilhelmy plate method on a Kruss Digital Tensiometer # K10ST. A vertical plate, typically made of platinum of know perimeter is attached to a balance and the force due to wetting is measured using a digital tensiometer as the plate is lowered into the film-forming composition.

Viscosity measurements were performed using a SR5 controlled stress rheometer from Texas Instruments. All measurements were made at 25°C; temperature was controlled using a Peltier heater. A 40 mm parallel plate fixture was used. Samples were loaded onto the bottom plate using a disposable pipette; plate gaps were 0.3 mm nominal. Shear stresses were applied to obtain shear rates between 100 and 1000 sec⁻¹ at five evenly spaced points on a logarithmic scale. 45 seconds of settling time and 15 seconds of measurement time were used at each point.

Surface roughness and edge shape is measured on a Tencor P-2 Profiler. To determine surface roughness the substrate is placed on the sample holder with the area to be scanned about 10mm in from the edge. The scan length is 1 millimeter and sampled every 40 microns. At the beginning of the scan, a 2 mg force is applied to the 5 micron tip. To determine edge shape, bumps, and cleanliness of the residue removal process, particularly on the edge bead, a scan is started on the substrate surface and moved to the area on the substrate that was treated with removal solvent (scan typically starts 150 to 200 microns from the film edge). The scan continues over the edge and onto the flat film surface until the scan is completed. The shape of the edge, the height of bump, and film thickness are then determined from the scan.

### COMPARISON OF SOLVENTS FOR REMOVAL OF EDGE BEAD

The films used to demonstrate the effectiveness of the methods and removal solvents disclosed herein are approximately 3000Å thick with a dielectric constant of 2.2. The film-forming composition was prepared in the following manner. A first solution, or solution A, containing 22.5g of tetraethoxysilane (TEOS), 22.5g methyltriethoxysilane (MTES), 140g propylene glycol propyl ether (PGPE), and 9.7g of octyphenol ethoxylate or the surfactant having the trade name Triton X-114, were mixed together in one bottle. In a separate bottle, 24g of 0.1 M HNO₃ and 1 g of an aqueous solution of 2.4 wt% tetramethylammonium hydroxide (TMAH) were mixed together to provide solution B. Solution B was added to solution A under continuous stirring. The final composition was aged statically for 16-24 hours under ambient conditions.

All components within the film-forming composition and the film processing steps, including the solvent used to perform remove the silicon-containing residue or edge bead, are purified to less than 1 ppm of alkali metal in a process similar to that described Pending U.S. Published Application 2004-0048960, which is incorporated herein by reference and assigned to the assignee of the present application. Unless otherwise stated, the spin-coating conditions used to deposit the film onto 200 and 300 mm substrates in an open spinning bowl configuration were as follows. The substrate was spun at 2000 rpm for 15 sec (5000 rpm/sec acceleration rate); the film-forming composition was dispensed onto the substrate initially spun at 500 rpm for 8 sec (1000 rpm/sec acceleration rate, dispense solution) and then spun 2000 rpm for 6 sec to distribute the composition over the substrate (30000 rpm/sec acceleration rate, spread); the coated substrate was then spun at 1200 rpm for 15 sec in a first drying step (3000 rpm/sec acceleration rate, dry 1) and 1800 rpm for 10 sec in a second drying step (30000 rpm/sec acceleration rate, dry 2).

The top side treatment step or top side EBR was performed using either a 0.51 millimeter (mm) inner diameter (ID) nozzle using a removal solvent pressurized at 15 psig or with a 0.61 mm ID nozzle at a flow rate of 60 ml/min for 9 seconds at a distance of 4-5 mm from the edge of the substrate after which the nozzle moved to the substrate edge during the next 4 seconds (total exposure time was 13 seconds). The identity of the removal solvent used to perform the top side EBR, the total solubility parameter, surface tension, boiling point (BP), vapor pressure, and viscosity of each solvent, are provided in Table I. The nozzle was oriented at a 60° angle with respect to the substrate surface and 90°C to the edge of the substrate. The solvent was dispensed onto the coated substrate and spun at 1200 rpm for 15 sec (3000 rpm/sec acceleration rate, top side edge bead removal) and then 2000 rpm for 10 sec to dry (1000 rpm/sec acceleration rate, final dry) to provide a treated substrate. Once the final drying was complete, no further solvents were dispensed onto the treated substrate prior to baking or curing, i.e., EBR is completed prior to any baking or curing steps. After the film was deposited, leveled, and dried, it was calcined in air at 90°C for 90 seconds, 180°C for 90 seconds, and 180 seconds at 400°C to obtain a fully cured optical quality low dielectric constant film without striations.

After the substrate was processed, the edge of the substrate was examined by profilometry and optical photography to check the cleanliness of the substrate edge (reported as "edge effect") and to determine if there was any change to the surface planarity of the film (reported as "bump"). The results of this examination are provided in Table II. Table II illustrates that only one solvent, or ethyl acetoacetate in Example 1, provided a clean substrate edge and did not affect the surface planarity of the film. The results in Table II demonstrate that an effective removal solvent has at least one of the following parameters: a vapor pressure less than 0.1 psia; an ester functionality; a viscosity of 2.5 cP or less; a boiling point of 120°C or greater; a total solubility parameter (δ) of 17 (J/cm³)^{1/2} or greater; and a surface tension (γ) of 22 dyne/cm or greater.

**Table II:**

| Effect of Different Removal Solvents on Residue Removal Using Same Processing Conditions | | | | | | | | |
|---|---|---|---|---|---|---|---|---|
| Ex | Solvent | δ (J/cm³)^{1/2} | γ (dyne/cm) | BP (°C) | P_{VAP} (psia) | η (cP) | Edge Effect? | Bump? |
| Ex. 1 | Ethyl Acetoacetate | 19.84 | 31.8 | 181 | 0.015 | 1.53 | none | No |
| Comp. Ex. 1 | Water | 47.81 | 72.8 | 100 | 0.46 | 0.91 | none | Yes |
| Comp. Ex. 2 | Propylene Glycol Propyl Ether | 19.93 | 25.4 | 150 | 0.04 | 2.4 | not clean | yes |
| Comp. Ex. 3 | Ethanol | 26.14 | 22.1 | 78 | 1.15 | 1.08 | none | yes |
| Comp. Ex. 4 | Diacetone Alcohol | 19.53 | 29.7 | 168 | 0.028 | 2.91 | bleeding | no |
| Comp. Ex. 5 | Ethyl Lactate | 22.38 | 28.4 | 155 | 0.015 | 2.56 | not clean | no |
| Comp. Ex. 6 | Isopropanol | 23.42 | 21 | 82 | 0.878 | 2.06 | none | yes |

### EFFECT OF VARYING EBR PROCESS PARAMETERS

The process for removal of silicon-containing edge beads or other residues may also be influenced by process parameters. Edge bead studies were conducted on 200 and 300 mm substrates using the removal solvent of Example 1 or ethyl acetoacetate for 3000Å thick films having a dielectric constant of 2.2. The films were prepared in the same manner as described above in Example 1 and Comparative Examples 2-6.

The EBR removal process was conducted using varying process parameters such as nozzle height at a distance of 1, 2, 3 mm from the test substrate; attack angle of solvent dispensing nozzle at 30°, 45° and 60°; twist angle (with regard to the angle of rotation of the substrate) at 60°, 90° and 120°; film dry time at 30, 40 and 50 seconds after EBR removal; EBR dispense time at 5, 10, and 15 seconds; EBR pressure at 5, 10, and 15 psi; and size of the nozzle tip at 0.3, 0.4, and 0.5 mm. The results were analyzed using a 7-factor Box Behnken design and are provided in Table III. The edges were visually observed for each test substrate and ranked from 1 to 5 with 5 being "neat" or having a clean edge. The bump height was measured in angstroms. The Behnken design for an experiment identifies which one of the factors has the strongest effect on the intended results. Further, the Behnken design for the experiment also determines if there is any correlation with regard to other factors.

The results in Table II indicate that the most important process variable for treating and removing residues was nozzle size. A relatively larger nozzle size provided better results. Further higher pressures for ejecting the removal solvent and/or longer treatment times also provided better results.

**Table III**

| **Height (mm)** | **Angle (°)** | **Rotation (°)** | **Time after dispense (s)** | **EBR time (s)** | **Press (psig)** | **Size (mm)** | **0=no removal 5=clean edge** |
|---|---|---|---|---|---|---|---|
| 2 | 45 | 90 | 30 | 5 | 5 | 0.41 | 1 |
| 2 | 45 | 90 | 50 | 5 | 5 | 0.41 | 2 |
| 2 | 45 | 90 | 30 | 15 | 5 | 0.41 | 3 |
| 2 | 45 | 90 | 50 | 15 | 5 | 0.41 | 3 |
| 2 | 45 | 90 | 30 | 5 | 15 | 0.41 | 5 |
| 2 | 45 | 90 | 50 | 5 | 15 | 0.41 | 5 |
| 2 | 45 | 90 | 30 | 15 | 15 | 0.41 | 5 |
| 2 | 45 | 90 | 50 | 15 | 15 | 0.41 | 5 |
| 1 | 45 | 90 | 40 | 10 | 5 | 0.31 | 1 |
| 3 | 45 | 90 | 40 | 10 | 5 | 0.31 | 1 |
| 1 | 45 | 90 | 40 | 10 | 15 | 0.31 | 5 |
| 3 | 45 | 90 | 40 | 10 | 15 | 0.31 | 5 |
| 1 | 45 | 90 | 40 | 10 | 5 | 0.51 | 1 |
| 3 | 45 | 90 | 40 | 10 | 5 | 0.51 | 5 |
| 1 | 45 | 90 | 40 | 10 | 15 | 0.51 | 5 |
| 3 | 45 | 90 | 40 | 10 | 15 | 0.51 | 5 |
| 2 | 30 | 90 | 40 | 5 | 10 | 0.31 | 1 |
| 2 | 60 | 90 | 40 | 5 | 10 | 0.31 | 4 |
| 2 | 30 | 90 | 40 | 15 | 10 | 0.31 | 3 |
| 2 | 60 | 90 | 40 | 15 | 10 | 0.31 | 3 |
| 2 | 30 | 90 | 40 | 5 | 10 | 0.51 | 4.75 |
| 2 | 60 | 90 | 40 | 5 | 10 | 0.51 | 3.5 |
| 2 | 30 | 90 | 40 | 15 | 10 | 0.51 | 5 |
| 2 | 60 | 90 | 40 | 15 | 10 | 0.51 | 5 |
| 1 | 30 | 90 | 30 | 10 | 10 | 0.41 | 4.8 |
| 3 | 30 | 90 | 30 | 10 | 10 | 0.41 | 4 |
| 1 | 60 | 90 | 30 | 10 | 10 | 0.41 | 5 |
| 3 | 60 | 90 | 30 | 10 | 10 | 0.41 | 5 |
| 1 | 30 | 90 | 50 | 10 | 10 | 0.41 | 3 |
| 3 | 30 | 90 | 50 | 10 | 10 | 0.41 | 2 |
| 1 | 60 | 90 | 50 | 10 | 10 | 0.41 | 5 |
| 3 | 60 | 90 | 50 | 10 | 10 | 0.41 | 5 |
| 2 | 45 | 60 | 30 | 10 | 10 | 0.31 | 4.5 |
| 2 | 45 | 120 | 30 | 10 | 10 | 0.31 | 3.5 |
| 2 | 45 | 60 | 50 | 10 | 10 | 0.31 | 3 |
| 2 | 45 | 120 | 50 | 10 | 10 | 0.31 | 2.5 |
| 2 | 45 | 60 | 30 | 10 | 10 | 0.51 | 5 |
| 2 | 45 | 120 | 30 | 10 | 10 | 0.51 | 4 |
| 2 | 45 | 60 | 50 | 10 | 10 | 0.51 | 5 |
| 2 | 45 | 120 | 50 | 10 | 10 | 0.51 | 4 |
| 1 | 45 | 60 | 40 | 5 | 10 | 0.41 | 5 |
| 3 | 45 | 60 | 40 | 5 | 10 | 0.41 | 5 |
| 1 | 45 | 120 | 40 | 5 | 10 | 0.41 | 5 |
| 3 | 45 | 120 | 40 | 5 | 10 | 0.41 | 5 |
| 1 | 45 | 60 | 40 | 15 | 10 | 0.41 | 5 |
| 3 | 45 | 60 | 40 | 15 | 10 | 0.41 | 5 |
| 1 | 45 | 120 | 40 | 15 | 10 | 0.41 | 5 |
| 3 | 45 | 120 | 40 | 15 | 10 | 0.41 | 5 |
| 2 | 30 | 60 | 40 | 10 | 5 | 0.41 | 2 |
| 2 | 60 | 60 | 40 | 10 | 5 | 0.41 | 5 |
| 2 | 30 | 120 | 40 | 10 | 5 | 0.41 | 3 |
| 2 | 60 | 120 | 40 | 10 | 5 | 0.41 | 1.5 |
| 2 | 30 | 60 | 40 | 10 | 15 | 0.41 | 5 |
| 2 | 60 | 60 | 40 | 10 | 15 | 0.41 | 5 |
| 2 | 30 | 120 | 40 | 10 | 15 | 0.41 | 4.75 |
| 2 | 60 | 120 | 40 | 10 | 15 | 0.41 | 1.5 |
| 2 | 45 | 90 | 40 | 10 | 10 | 0.41 | 5 |
| 2 | 45 | 90 | 40 | 10 | 10 | 0.41 | 5 |
| 2 | 45 | 90 | 40 | 10 | 10 | 0.41 | 5 |
| 2 | 45 | 90 | 40 | 10 | 10 | 0.41 | 5 |
| 2 | 45 | 90 | 40 | 10 | 10 | 0.41 | 5 |

## Claims

1. A method for removing residues comprising silicon from at least a portion of coated substrate and/or deposition apparatus, the method comprising:
treating the coated substrate and/or deposition apparatus with a removal solvent that boils at a temperature ranging from 120°C to 250°C and has a viscosity of 2.5 centipoise or less.

2. The method of claim 1 wherein the removal solvent has a surface tension of 22 dyne/cm or greater.

3. The method of claim 1 wherein the removal solvent has a total solubility parameter of 17 (J/cm³)^{1/2} or greater.

4. The method of claim 1 wherein removal solvent boils at a temperature ranging from 150°C to 250°C.

5. The method of claim 1 wherein the removal solvent comprises a compound having the following formula: R¹⁴COR¹⁵CO₂R¹⁶ where R¹⁴ and R¹⁵ are each independently a hydrocarbon group having from 1 to 6 carbon atoms and R¹⁶ is a hydrocarbon group having from 1 to 4 carbon atoms.

6. The method of claim 5 wherein the compound is at least one selected from ethylacetoacetate, methyl acetoacetate, allyl acetoacetate, t-butyl acetoacetate, ethyl-3-ethoxypropionate, and 2-butoxyethyl acetate.

7. The method of claim 6 wherein the compound is ethylacetoacetate.

8. The method of 1 wherein the removal solvent comprises a compound having the following formula: R¹⁷₃CCO₂-R¹⁸ where R¹⁷ is independently a H atom, an alkoxy group having from 1 to 4 carbon atoms, or a hydrocarbon group having from 1 to 4 carbon atoms and R¹⁸ is a hydrocarbon having from 1 to 8 carbon atoms, an alkyl ether group -(CH₂)ₙ-O-R¹⁹ wherein R¹⁹ is an alkyl group having from 1 to 4 carbon atoms, n is a number ranging from 1 to 4, or an alkylene glycol alkyl ether where the alkylene glycol has from 2 to 4 carbon atoms and the alkyl group has from 1 to 5 carbon atoms.

9. The method of claim 8 wherein the compound is at least one selected from di-n-propyl carbonate and hexyl acetate.

10. The method of claim 1 wherein the compound is at least one selected from acetophone, benzylamine, furfural, diglyme, and tetramethyl urea.

11. A method for removing residues comprising silicon from at least a portion of coated substrate and/or deposition apparatus, the method comprising:
treating the coated substrate and/or deposition apparatus with a removal solvent comprising a compound selected from the group consisting of:
a compound having the following formula: R¹⁴COR¹⁵CO₂R¹⁶ where R¹⁴ and R¹⁵ are each independently a hydrocarbon group having from 1 to 6 carbon atoms and R¹⁶ is a hydrocarbon group having from 1 to 4 carbon atoms;
a compound having the following formula: R¹⁷₃CCO₂-R¹⁸ where R¹⁷ is independently a H atom, an alkoxy group having from 1 to 4 carbon atoms, or a hydrocarbon group having from 1 to 4 carbon atoms and R¹⁸ is a hydrocarbon having from 1 to 8 carbon atoms, an alkyl ether group - (CH₂)ₙ-O-R¹⁹ wherein R¹⁹ is an alkyl group having from 1 to 4 carbon atoms, n is a number ranging from 1 to 4, or an alkylene glycol alkyl ether where the alkylene glycol has from 2 to 4 carbon atoms and the alkyl group has from 1 to 5 carbon atoms; and
mixtures thereof.

12. The method of claim 11 wherein the removal solvent boils at a temperature ranging from 120 to 250°C.

13. The method of claim 11 wherein the removal solvent boils at a temperature ranging from 150 to 250°C.

14. The method of claim 11 wherein the removal solvent has a surface tension of 22 dyne/cm or greater.

15. The method of claim 11 wherein the removal solvent has a viscosity of 2.5 centipoise of less.

16. The method of claim 11 wherein the removal solvent further has a total solubility parameter of 17 (J/cm³)^{1/2} or greater.

17. A method for removing residues comprising silicon from at least a portion of a coated substrate comprising:
preparing a film-forming composition comprising at least one silica source and at least one solvent;
depositing the film-forming composition onto a substrate to provide a coated substrate comprising a silicon-containing film and residues comprising silicon using a deposition apparatus;
drying the coated substrate;
treating the coated substrate with a removal solvent to remove at least a portion of the residues;
removing the removal solvent and residues from the coated substrate to provide a treated substrate;
drying the treated substrate; and
curing the treated substrate.

18. The method of claim 17 further comprising contacting the deposition apparatus with the removal solvent to remove residues contained thereupon.

19. The method of claim 17 wherein the removal solvent boils at a temperature ranging from 120 to 250°C.

20. The method of claim 19 wherein the removal solvent boils at a temperature ranging from 150 to 250°C.

21. The method of claim 19 wherein the removal solvent has a viscosity of 2.5 centipoise or less.

22. The method of claim 19 wherein the removal solvent has a surface tension of 22 dyne/cm or greater.

23. The method of claim 19 wherein the removal solvent has a total solubility parameter of 17 (J/cm³)^{1/2} or greater.

24. The method of claim 19 wherein the removal solvent comprises a compound having the general structure: R¹⁴COR¹⁵CO₂R¹⁶ where R¹⁴ and R¹⁵ are each independently a hydrocarbon group having from 1 to 6 carbon atoms and R¹⁶ is a hydrocarbon group having from 1 to 4 carbon atoms.

25. The method of claim 24 wherein the removal solvent comprises a compound selected from the group consisting of ethylacetoacetate, methyl acetoacetate, allyl acetoacetate, t-butyl acetoacetate, ethyl-3-ethoxypropionate, and 2-butoxyethyl acetate, and mixtures thereof.

26. The method of claim 25 wherein the removal solvent comprises ethylacetoacetate.

27. The method of claim 19 wherein the removal solvent comprises a compound having the general structure R¹⁷₃CCO₂-R¹⁸ where R¹⁷ is independently a H atom, an alkoxy group having from 1 to 4 carbon atoms, or a hydrocarbon group having from 1 to 4 carbon atoms and R¹⁸ is a hydrocarbon having from 1 to 8 carbon atoms, an alkyl ether group -(CH₂)ₙ-O-R¹⁹ wherein R¹⁹ is an alkyl group having from 1 to 4 carbon atoms, n is a number ranging from 1 to 4, or an alkylene glycol alkyl ether where the alkylene glycol has from 2 to 4 carbon atoms and the alkyl group has from 1 to 5 carbon atoms.

28. The method of claim 27 wherein the removal solvent comprises a compound selected from the group consisting of di-n-propyl carbonate, hexyl acetate, and mixtures thereof.

29. The method of claim 17 where the treating step comprises ejecting the removal solvent from a nozzle and rotating the coated substrate during at least a portion of ejecting.

30. The method of claim 29 wherein an inner diameter of the nozzle is 0.7 mm or less.

31. The method of claim 29 wherein the nozzle is oriented 90° to the substrate.

32. The method of claim 29 wherein the nozzle is oriented 60° to the substrate surface.

33. The method of claim 29 wherein the removal solvent is ejected from the nozzle using gas pressure.

34. The method of claim 29 wherein the removal solvent is ejected from the nozzle by mechanical means.

35. The method of claim 29 wherein the coated substrate is rotated at a speed ranging from 500 to 3000 rpm.

36. The method of claim 17 wherein the duration of the treating step ranges from 1 to 180 seconds.

37. The method of claim 17 wherein treating and drying steps are conducted prior to the curing step.

38. The method of claim 17 wherein the at least one solvent in the film-forming composition and the removal solvent are the same.

39. The method of claim 17 wherein the at least one solvent in the film-forming composition and the removal solvent are different.

40. The method of claim 17 wherein the removal solvent has a metal purity level of about 500 ppm or less.
